(19) Europäisches Patentamt

European Patent Office

Office européen des brevets

(11) Veröffentlichungsnummer: **0 090 169**
A2

# (12) EUROPÄISCHE PATENTANMELDUNG

(21) Anmeldenummer: **83101568.0**

(22) Anmeldetag: **18.02.83**

(51) Int. Cl.³: **H 01 L 29/747**

(30) Priorität: **23.02.82 DE 3206477**

(43) Veröffentlichungstag der Anmeldung: **05.10.83**
**Patentblatt 83/40**

(84) Benannte Vertragsstaaten: **CH DE FR GB IT LI**

(71) Anmelder: **SIEMENS AKTIENGESELLSCHAFT, Berlin
und München Wittelsbacherplatz 2,
D-8000 München 2 (DE)**

(72) Erfinder: **Fellinger, Christine, Germersheimerstrasse 5,
D-8000 München 90 (DE)**
Erfinder: **Leipold, Ludwig, Dipl.-Ing.,
Kurt-Eisner-Strasse 41, D-8000 München 83 (DE)**
Erfinder: **Tihanyi, Jenö, Dr. Ing., Wolfratshauser
Strasse 179 b, D-8000 München 71 (DE)**

(54) **Feldeffektgesteuerter Triac.**

㉗ Der feldeffektgesteuerte Triac besteht aus mehreren, nach Art einer Kammstruktur einander zugeordneten parallelen streifenförmigen und gleich orientierten Einheiten (1, 2, 3). Jede Einheit umfaßt eine streifenförmige Anodenzone (11, 21, 31) des ersten Teilthyristors und eine streifenförmige katodenseitige Basiszone (12, 22, 32) des zweiten Teilthyristors, in die die Sourcezone (14, 24, 34) eines FET und eine streifenförmige Katodenzone (13, 23, 33) eingebettet ist. Basiszone und Anodenzone derselben Einheit sind über eine Leiterbahn (18, 28, 38) miteinander verbunden. Die Leiterbahnen der ersten, dritten, fünften usw. Einheit und die der zweiten, vierten, sechsten usw. Einheit sind jeweils elektrisch miteinander verbunden.

SIEMENS AKTIENGESELLSCHAFT
Berlin und München

Unser Zeichen
VPA  82 P 1 1 2 0 E

0090169

Feldeffektgesteuerter Triac

Die vorliegende Erfindung bezieht sich auf einen feldgesteuerten Triac mit einem Substrat, in dessen eine Oberfläche die katodenseitigen Basiszonen und die Anodenzonen von den Triac bildenden antiparallel geschalteten Teilthyristoren eingebettet sind, mit den Teilthyristoren zugeordneten Katodenzonen, die in diesen Basiszonen eingebettet sind, mit einem Feldeffekttransistor (FET), dessen Sourcezone in eine katodenseitige Basiszone eingebettet ist und dessen Kanalzone Teil dieser Basiszone ist, mit einer Gateelektrode, die mindestens die Kanalzone überdeckt, mit Katoden- und Anodenelektroden, von denen die Katodenelektrode des ersten Teilthyristors mit der Anodenelektrode des zweiten Teilthyristors elektrisch verbunden ist und umgekehrt.

Ein feldgesteuerter Triac dieser Gattung ist z. B. in der DE-OS 30 19 883 beschrieben worden. Die den beiden antiparallel geschalteten Teilthyristoren zugeordneten Zonen sind derart angeordnet, daß die Katodenzone und die katodenseitige Basiszone des ersten Teilthyristors seiner Anodenzone gegenüberliegt. Daneben sind spiegelbildlich die Zonen des zweiten Teilthyristors derart angeordnet, daß die Anodenzone des ersten Teilthyristors auch die katodenseitige Basiszone des zweiten Teilthyristors bildet. Ein Teil der katodenseitigen Basiszone des ersten Teilthyristors bildet die Kanalzone des FET. Der erste Teilthyristor wird über den FET direkt gezündet, während der antiparallel geschaltete zweite Teilthyristor des Triacs über einen Widerstand und eine zusätzliche, in das Substrat eingebettete Hilfszone gezün-

Hab 1 Dx / 18.02.1982

det wird. Dies führt zu Unsymmetrien bei der Zündung. Außerdem ist die gewählte Form der Zonen der Teilthyristoren für höhere Leistung nur dann integrationsfähig, wenn eine mehrschichtige Metallisierung angewendet wird.

Der Erfindung liegt die Aufgabe zugrunde, einen feldgesteuerten Triac der oben erwähnten Gattung so weiterzubilden, daß die Symmetrie des Zündverhaltens sichergestellt ist. Außerdem soll der Triac für höhere Leistungen gut integrierbar sein, ohne daß eine Mehrschicht-Metallisierung erforderlich ist.

Die Erfindung ist dadurch gekennzeichnet, daß die genannten Zonen streifenförmig ausgebildet sind und einander parallel liegen, daß jeweils neben einer Anodenzone eine Basiszone derart angeordnet ist, daß deren Kanalzone einer Längsseite der Anodenzone gegenüberliegt, daß die Anodenzone mit der in dieser Basiszone eingebetteten Katodenzone elektrisch zu einer Einheit verbunden ist, daß mindestens drei dieser Einheiten in gleicher Orientierung nebeneinander angeordnet sind und daß die erste, dritte, fünfte usw. Einheit miteinander und die zweite, vierte, sechste usw. Einheit elektrisch miteinander verbunden ist.

Weiterbildungen der Erfindung sind Gegenstand der Unteransprüche.

Die Erfindung wird an Hand eines Ausführungsbeispiels sowie einer Abwandlung in Verbindung mit den Fig. 1 bis 3 näher erläutert. Es zeigen:

Fig. 1 eine perspektivische Ansicht eines Teilbereichs des Triacs,

Fig. 2 eine Aufsicht auf den Teilbereich des Triacs nach Fig. 1 und

Fig. 3 eine weitere Ausführungsform eines Teils des
Triacs.

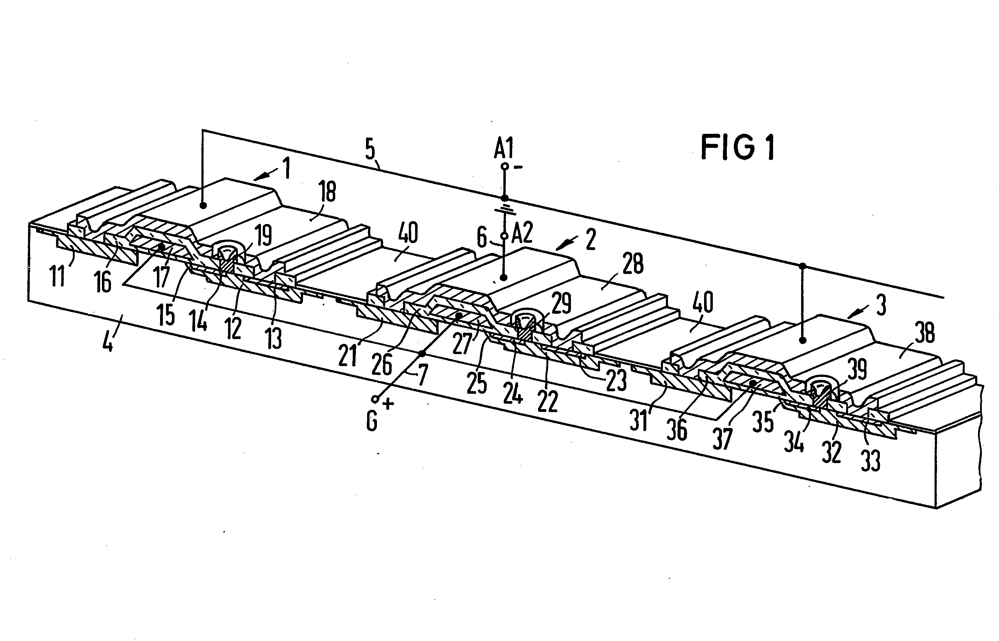

Der Triac nach Fig. 1 ist auf einem Substrat 4 aufgebaut, das beispielsweise schwach n-dotiert ist. Er weist
n vorzugsweise identisch aufgebaute Einheiten auf, die
an der Oberseite des Substrats 4 angebracht sind. In
Fig. 1 sind lediglich drei Einheiten 1, 2 und 3 dargestellt. Zur Erläuterung des Aufbaus wird auf die Einheit 1 Bezug genommen. Die anderen Einheiten 2 und 3
tragen anstelle der der Einheit 1 zugeordneten Bezugsziffern 11 ... 19 die Bezugsziffern 21 ... 29 und
31 ... 39.

Die Einheit 1 weist eine z. B. $p^+$-dotierte streifenförmige Zone 11 auf, die in die obere Oberfläche des z. B.
schwach n-dotierten Substrats 4 eingebettet ist. Parallel zur Zone 11 ist in der Oberfläche des Substrats 4
eine streifenförmige beispielsweise p-dotierte Zone 12
angeordnet. In der Zone 12 sind zwei streifenförmige zu
den Zonen 11, 12 parallele Zonen 14 und 13 eingebettet.
Diese sind beispielsweise n-dotiert bzw. stark n-dotiert.
Die Zone 11 bildet die Anodenzone des ersten Teilthyristors, die Zone 12 die katodenseitige Basiszone des zweiten Teilthyristors und die Zone 13 die Katodenzone des
zweiten Teilthyristors. Die Zone 14 ist die Sourcezone
eines FET. Die Kanalzone des FET ist mit 15 bezeichnet.
Sie ist Bestandteil der Zone 12 und liegt einer Längsseite der Anodenzone 11 gegenüber.

Die Kanalzone 15 des FET ist von einer Gateelektrode 17
überdeckt, die beispielsweise aus stark n-dotiertem Polysilicium besteht. Die Gateelektrode ist durch eine Isolierschicht 16 gegen die Oberfläche des Substrats 4 isoliert. Die Gateelektrode 17 kann, wie dargestellt, auch den an die Oberfläche tretenden Teil des Substrats 4 überdecken und ein Teil der Zone 11 überlappen. Dies verbessert die Leitfähigkeit in unter der Gateelektrode liegenden Teilen des Substrats durch Akkumulation von Ladungsträgern. Die Katodenzone 13 des zweiten Teilthyristors und die Anodenzone 11 des ersten Teilthyristors sind durch eine Leiterbahn 18 elektrisch miteinander verbunden. Die Sourcezone 14 ist durch einen Kontakt 19 mit der Basiszone 12 verbunden.

In der Einheit 2 bildet die Zone 21 die Anodenzone des zweiten Teilthyristors, während die Zone 23 die Katodenzone des ersten Teilthyristors ist. In der Einheit 3 bildet die Zone 31 wieder die Anodenzone des ersten Teilthyristors und die Zone 33 die Katodenzone des zweiten Teilthyristors. Dabei ist jedem der Teilthyristoren eine Sourcezone und eine Kanalzone nebst zugehöriger Gateelektrode zugeordnet. Das heißt, daß jeder Teilthyristor durch einen FET gesteuert wird.

Die Einheiten 1 und 3 sind durch eine Leitung 5 elektrisch verbunden und zu einem Anschluß A 1 für die Anode 1 zusammengefaßt. Die Einheit 2 ist über eine Leitung 6 mit einem Anschluß A 2 für die Anode 2 verbunden. Die Leitung 6 kann zu in Fig. 1 nicht dargestellten Einheiten 4, 6 usw. führen, während die Leitung 5 weitere nicht dargestellte Einheiten 5, 7 usw. elektrisch mit den Einheiten 1 und 3 verbinden kann. Die Gateelektroden 17, 27 und 37 und eventuelle weitere Gateelektroden sind über eine Leitung 7 mit einem Anschluß G für die Gatevorspannung verbunden.

Zur Erläuterung der Funktionsweise wird angenommen, daß an der Anode A 1 negative Polarität liegt, während die Anode A 2 auf Nullpotential liegt. Bei positiver Gatespannung öffnen die Kanäle 15, 35 und es fließen negative Ladungsträger aus den Katodenzonen 13, 33 über die Sourcezonen 14, 34, die Kanäle 15, 35 in das Substrat 4, das die Drainzone des FET bildet. Die negativen Ladungsträger fließen zur Anodenzone 21 der Einheit 2 bzw. zur Anodenzone einer eventuellen weiteren Einheit 4 usw. und führen so zur Emission von positiven Ladungsträgern aus der Anodenzone 21 in Richtung zur Basiszone 12 bzw. zur Basiszone 32. Dies hat eine Emission von negativen Ladungsträgern aus den Katodenzonen 13, 33 in die Basiszonen 12, 32 zur Folge, wodurch der aus den Zonen 13, 12, 4, 21 und den Zonen eventueller weiterer Einheiten bestehende zweite Teilthyristor zündet. Bei umgekehrter Polarität, das heißt negatives Potential an A 2 und Nullpotential an A 1, zündet der aus den Zonen 23, 22, 4, 31 bestehende erste Teilthyristor.

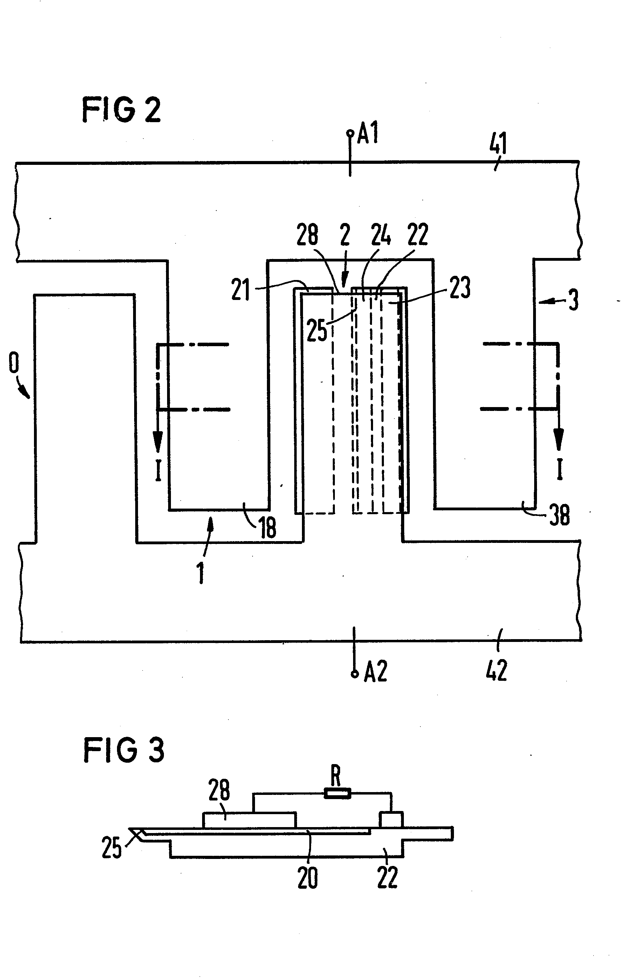

In Fig. 1 wurde die Verbindung der einzelnen Einheiten als Leitungen dargestellt. Es ist jedoch zweckmäßig, die elektrischen Verbindungen wie in der Technik der integrierten Schaltungen üblich durch Leiterbahnen herzustellen. Dies ist in Fig. 2 dargestellt. Der besseren Übersichtlichkeit halber wurden hier nur die Zonen der Einheit 2 gestrichelt eingezeichnet. Die Gateelektrode 27, der Kontakt 29 und die Isolierschicht 26 wurden der besseren Übersichtlichkeit halber ebenfalls weggelassen. Die Einheiten 1 und 3 sind hier durch eine weitere Leiterbahn 41 elektrisch verbunden. Die Einheiten 1, 3, 5 usw. bilden zusammen eine kammartige Struktur. Die Einheiten 0, 2, 4, usw. sind über eine weitere Leiterbahn 42 elektrisch verbunden und bilden mit dieser ebenfalls eine kammartige Struktur. Beide kammartigen Strukturen greifen ineinander. Dabei sind die Einheiten und die Zonen stets parallel zueinander angeordnet und gleichartig orientiert.

In Fig. 1 sind die Katodenzonen 13, 23, 33 und die Sourcezonen 14, 24, 34 getrennte Zonen. Sie können jedoch auch jeweils eine gemeinsame Zone bilden, wie dies in Fig. 3 dargestellt und für die Einheit 2 mit 20 bezeichnet ist. Die Zone 20 ist hierbei über einen Widerstand R und einen weiteren Kontakt mit der katodenseitigen Basiszone 22 verbunden.

3 Figuren
7 Patentansprüche

0090169

## Patentansprüche

1. Feldgesteuerter Triac mit einem Substrat (4), in dessen eine Oberfläche die katodenseitigen Basiszonen (12, 22, 32) und die Anodenzonen (11, 21, 31) von den Triac bildenden antiparallel geschalteten Teilthyristoren eingebettet sind, mit den Teilthyristoren zugeordneten Katodenzonen (13, 23, 33), die in diesen Basiszonen eingebettet sind, mit einem FET, dessen Sourcezone (14, 24, 34) in eine katodenseitige Basiszone eingebettet ist und dessen Kanalzone (15, 25, 35) Teil dieser Basiszone ist, mit einer Gateelektrode (17, 27, 37), die mindestens die Kanalzone überdeckt, mit Katoden- und Anodenelektroden (18, 28, 38), von denen die Katodenelektrode des ersten Teilthyristors mit der Anodenelektrode des zweiten Teilthyristors elektrisch verbunden ist und umgekehrt, d a d u r c h   g e k e n n z e i c h n e t ,   daß die genannten Zonen streifenförmig ausgebildet sind und einander parallel liegen, daß jeweils neben einer Anodenzone (11, 21, 31) eine Basiszone (12, 22, 32) derart angeordnet ist, daß deren Kanalzone (14, 24, 34) einer Längsseite der Anodenzone gegenüberliegt, daß die Anodenzone mit der in dieser Basiszone eingebetteten Katodenzone (13, 23, 33) elektrisch zu einer Einheit (1, 2, 3) verbunden ist, daß mindestens drei dieser Einheiten in gleicher Orientierung nebeneinander angeordnet sind und daß die erste, dritte, fünfte usw. Einheit miteinander und die zweite, vierte, sechste usw. Einheit elektrisch miteinander verbunden ist.

2. Triac nach Anspruch 1,   d a d u r c h   g e - k e n n z e i c h n e t ,   daß die Anodenzone (11, 21, 31) mit der Katodenzone (13, 23, 33) jeder Einheit durch eine Leiterbahn (18, 28, 38) verbunden ist.

3. Triac nach Anspruch 2, d a d u r c h   g e - k e n n z e i c h n e t ,  daß die Leiterbahnen der ersten, dritten, fünften usw. Einheit und die Leiterbahnen der zweiten, vierten, sechsten usw. Einheit durch weitere Leiterbahnen (41, 42) zu je einer kammförmigen Struktur verbunden sind.

4. Triac nach einem der Ansprüche 1 bis 3, d a - d u r c h   g e k e n n z e i c h n e t ,  daß jede Einheit eine Gateelektrode (17, 27, 37) aufweist und daß alle Gateelektroden elektrisch miteinander verbunden sind.

5. Triac nach Anspruch 4, d a d u r c h   g e - k e n n z e i c h n e t ,  daß die Gateelektrode außer der Kanalzone auch noch das zwischen Kanalzone und Anodenzone liegende Teil des Substrats (4) überdeckt und die Anodenzone (11, 21, 31) überlappt.

6. Triac nach einem der Ansprüche 1 bis 5, d a - d u r c h   g e k e n n z e i c h n e t ,  daß die Sourcezone (14, 24, 34) und die Katodenzone (13, 23, 33) getrennte Zonen sind und daß die Sourcezone über einen Kontakt (19, 29, 39) elektrisch mit der katodenseitigen Basiszone verbunden ist.

7. Triac nach einem der Ansprüche 1 bis 5, d a - d u r c h   g e k e n n z e i c h n e t ,  daß die Sourcezone und die Katodenzone eine einzige Zone (20) bilden und daß diese Zone über einen Widerstand (R) mit der katodenseitigen Basiszone (22) verbunden ist.

FIG 1

## FIG 2

## FIG 3